# EUROPEAN PATENT APPLICATION

(11) **EP 1 640 323 A2**
(43) Date of publication of application: **29.03.2006**
(21) Application number: 05255644.6
(22) Date of filing: 14.09.2005
(51) Int. Cl.: B81B 7/00

(54) **System and method for display device with activated desiccant**

(30) Priority: 27.09.2004 US 613280 P; 27.05.2005 US 140498
(71) Applicant: IDC, LLC, San Francisco, CA 94107 (US)
(72) Inventor: Palmateer, Lauren, San Francisco, California 94102 (US); Cummings, William J., Millbrae, California 94030 (US); Gally, Brian J., Los Gatos, California 95032 (US); Sampsell, Jeffrey B., San Jose, California 95110 (US)
(74) Representative: Dunlop, Hugh Christopher

(57) **Abstract**

A MEMS device package 70 comprises a substrate 72 with a MEMS device 76 formed thereon, a backplane 74 a seal 78 and an inactive desiccant 80 within the package. The desiccant 80 is activated after assembly of the package by exposure to an environmental change or an activating substance. A method of manufacturing a MEMS device comprises activating a desiccant and contacting a substrate with the MEMS device formed thereon, a seal, and a backplane, wherein the desiccant is disposed on the substrate or the backplane.

## Description

### BACKGROUND

### Field of the Invention

The field of the invention relates to microelectromechanical systems (MEMS), and more particularly, to methods and systems for packaging MEMS devices.

### Description of the Related Art

Microelectromechanical systems (MEMS) include micromechanical elements, actuators, and electronics. Micromechanical elements may be created using deposition, etching, and or other micromachining processes that etch away parts of substrates and/or deposited material layers or that add layers to form electrical and electromechanical devices. One type of MEMS device is called an interferometric modulator. An interferometric modulator may comprise a pair of conductive plates, one or both of which may be transparent and/or reflective in whole or part and capable of relative motion upon application of an appropriate electrical signal. One plate may comprise a stationary layer deposited on a substrate, the other plate may comprise a metallic membrane separated from the stationary layer by an air gap. Such devices have a wide range of applications, and it would be beneficial in the art to utilize and/or modify the characteristics of these types of devices so that their features can be exploited in improving existing products and creating new products that have not yet been developed.

### SUMMARY

The system, method, and devices of the invention each have several aspects, no single one of which is solely responsible for its desirable attributes. Without limiting the scope of this invention, its more prominent features will now be discussed briefly. After considering this discussion, and particularly after reading the section entitled "Detailed Description of Certain Embodiments" one will understand how the features of this invention provide advantages over other display devices.

One embodiment of a microelectromechanical system (MEMS) device comprises a substrate, a MEMS device formed on the substrate, a backplane sealed to the substrate to form a MEMS device package, and an inactive desiccant positioned within the package.

In one embodiment, a MEMS device is produced by the method comprising providing a MEMS device package comprising a substrate comprising a MEMS device formed thereon, a backplane sealed to the substrate to encapsulate the MEMS device, and an inactive desiccant positioned within the MEMS device package, and activating the desiccant.

In one embodiment, a MEMS device package is produced by the method comprising activating a desiccant, and contacting a substrate, a seal, and a backplane so as to encapsulate a MEMS device formed on the substrate and the activated desiccant.

Yet another embodiment is a MEMS device comprising: transmitting means for transmitting light therethrough; modulating means for modulating light through said transmitting means; covering means for covering said modulating means and forming a package; and removing means for removing water vapor from within said package, wherein said removing means is in an inactive state.

### BRIEF DESCRIPTION OF THE DRAWINGS

Figure 1 is an isometric view depicting a portion of one embodiment of an interferometric modulator display in which a movable reflective layer of a first interferometric modulator is in a released position and a movable reflective layer of a second interferometric modulator is in an actuated position.
Figure 2 is a system block diagram illustrating one embodiment of an electronic device incorporating a 3x3 interferometric modulator display.
Figure 3 is a diagram of movable mirror position versus applied voltage for one exemplary embodiment of an interferometric modulator of Figure 1.
Figure 4 is an illustration of a set of row and column voltages that may be used to drive an interferometric modulator display.
Figures 5A and 5B illustrate one exemplary timing diagram for row and column signals that may be used to write a frame of display data to the 3x3 interferometric modulator display of Figure 2.
Figures 6A and 6B are system block diagrams illustrating an embodiment of a display device.
Figure 7A is a cross-sectional view of the device of Figure 1.
Figure 7B is a cross-sectional view of an alternative embodiment of an interferometric modulator.
Figure 7C is a cross-sectional view of another alternative embodiment of an interferometric modulator.
Figure 8 is a cross-sectional view of a basic package structure for an interferometric modulator device
Figure 9 is a cross-sectional view of one embodiment of a MEMS device package structure with an inactive desiccant.
Figure 10 is a cross-sectional view of an unassembled MEMS device package structure with an inactive desiccant.

### DETAILED DESCRIPTION OF THE PREFERRED EMBODIMENTS

The following detailed description is directed to certain specific embodiments of the invention. However, the invention can be embodied in a multitude of different ways. In this description, reference is made to the drawings wherein like parts are designated with like numerals throughout. As will be apparent from the following description, the embodiments may be implemented in any device that is configured to display an image, whether in motion (e.g., video) or stationary (e.g., still image), and whether textual or pictorial. More particularly, it is contemplated that the embodiments may be implemented in or associated with a variety of electronic devices such as, but not limited to, mobile telephones, wireless devices, personal data assistants (PDAs), hand-held or portable computers, GPS receivers/navigators, cameras, MP3 players, camcorders, game consoles, wrist watches, clocks, calculators, television monitors, flat panel displays, computer monitors, auto displays (e.g., odometer display, etc.), cockpit controls and/or displays, display of camera views (e.g., display of a rear view camera in a vehicle), electronic photographs, electronic billboards or signs, projectors, architectural structures, packaging, and aesthetic structures (e.g., display of images on a piece of jewelry). MEMS devices of similar structure to those described herein can also be used in non-display applications such as in electronic switching devices.

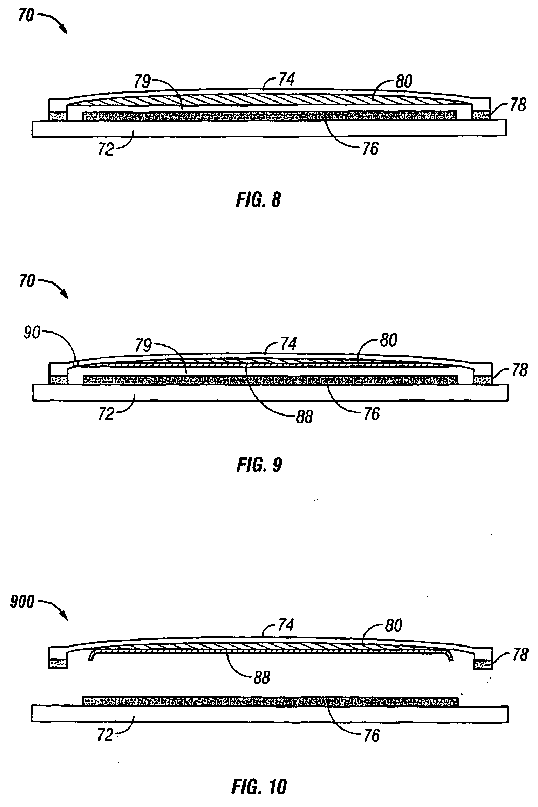

A plurality of embodiments of MEMS device package structures with improved moisture control properties are described below. One embodiment of the invention is a MEMS-based display device that is packaged between a backplane and a substrate with a seal. In this embodiment, the package also includes an inactive desiccant located within the device package. The desiccant can be activated either before or after sealing the package. For example, the inactive desiccant can be activated by exposure to environmental changes such as heat or UV light, or may be activated by contact with an activation substance. The inactive desiccant may be covered with one or more protective layers, wherein one of the protective layers is removed by contacting the protective layer with a removal substance through an aperture in the device package. In certain embodiments, a desiccant is activated prior to assembly of the MEMS device package. For example, the desiccant may be activated by removing a self-contained sheet protecting the desiccant from ambient conditions. These embodiments, as well as additional embodiments, are discussed in more detail below in reference to Figures 8-10.

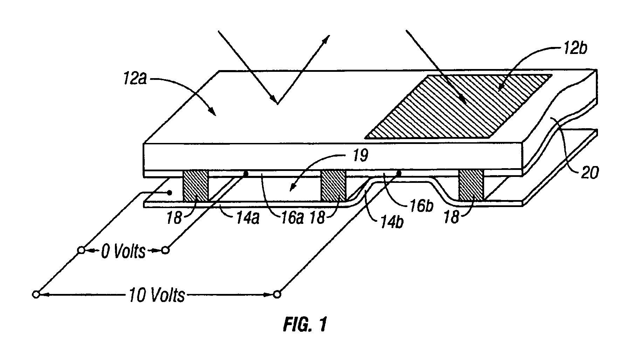

One interferometric modulator display embodiment comprising an interferometric MEMS display element is illustrated in Figure 1. In these devices, the pixels are in either a bright or dark state. In the bright ("on" or "open") state, the display element reflects a large portion of incident visible light to a user. When in the dark ("off" or "closed") state, the display element reflects little incident visible light to the user. Depending on the embodiment, the light reflectance properties of the "on" and "off" states may be reversed. MEMS pixels can be configured to reflect predominantly at selected colors, allowing for a color display in addition to black and white.

Figure 1 is an isometric view depicting two adjacent pixels in a series of pixels of a visual display, wherein each pixel comprises a MEMS interferometric modulator. In some embodiments, an interferometric modulator display comprises a row/column array of these interferometric modulators. Each interferometric modulator includes a pair of reflective layers positioned at a variable and controllable distance from each other to form a resonant optical cavity with at least one variable dimension. In one embodiment, one of the reflective layers may be moved between two positions. In the first position, referred to herein as the relaxed, the movable layer is positioned at a relatively large distance from a fixed partially reflective layer. In the second position, the movable layer is positioned more closely adjacent to the partially reflective layer. Incident light that reflects from the two layers interferes constructively or destructively depending on the position of the movable reflective layer, producing either an overall reflective or non-reflective state for each pixel.

The depicted portion of the pixel array in Figure 1 includes two adjacent interferometric modulators 12a and 12b. In the interferometric modulator 12a on the left, a movable and highly reflective layer 14a is illustrated in a relaxed position at a predetermined distance from a fixed partially reflective layer 16a. In the interferometric modulator 12b on the right, the movable highly reflective layer 14b is illustrated in an actuated position adjacent to the fixed partially reflective layer 16b.

The fixed layers 16a, 16b are electrically conductive, partially transparent and partially reflective, and may be fabricated, for example, by depositing one or more layers each of chromium and indium-tin-oxide onto a transparent substrate 20. The layers are patterned into parallel strips, and may form row electrodes in a display device as described further below. The movable layers 14a, 14b may be formed as a series of parallel strips of a deposited metal layer or layers (orthogonal to the row electrodes 16a, 16b) deposited on top of posts 18 and an intervening sacrificial material deposited between the posts 18. When the sacrificial material is etched away, the deformable metal layers 14a, 14b are separated from the fixed metal layers by a defined gap 19. A highly conductive and reflective material such as aluminum may be used for the deformable layers, and these strips may form column electrodes in a display device.

With no applied voltage, the cavity 19 remains between the layers 14a, 16a and the deformable layer is in a mechanically relaxed state as illustrated by the pixel 12a in Figure 1. However, when a potential difference is applied to a selected row and column, the capacitor formed at the intersection of the row and column electrodes at the corresponding pixel becomes charged, and electrostatic forces pull the electrodes together. If the voltage is high enough, the movable layer is deformed and is forced against the fixed layer (a dielectric material which is not illustrated in this Figure may be deposited on the fixed layer to prevent shorting and control the separation distance) as illustrated by the pixel 12b on the right in Figure 1. The behavior is the same regardless of the polarity of the applied potential difference. In this way, row/column actuation that can control the reflective vs. non-reflective pixel states is analogous in many ways to that used in conventional LCD and other display technologies.

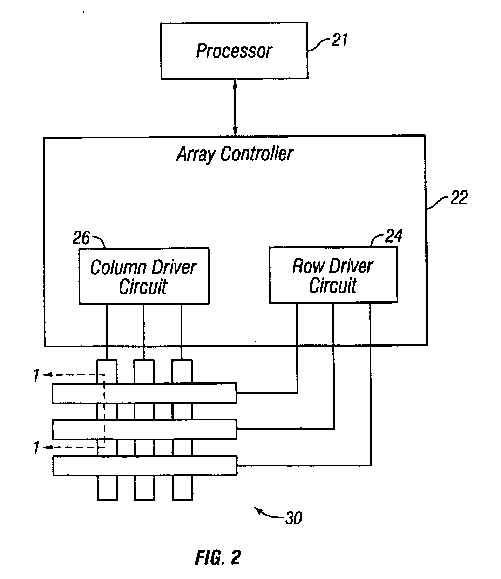

Figures 2 through 5 illustrate one exemplary process and system for using an array of interferometric modulators in a display application.

Figure 2 is a system block diagram illustrating one embodiment of an electronic device that may incorporate aspects of the invention. In the exemplary embodiment, the electronic device includes a processor 21 which may be any general purpose single- or multi-chip microprocessor such as an ARM, Pentium®, Pentium II®, Pentium III®, Pentium IV®, Pentium® Pro, an 8051, a MIPS®, a Power PC®, an ALPHA®, or any special purpose microprocessor such as a digital signal processor, microcontroller, or a programmable gate array. As is conventional in the art, the processor 21 may be configured to execute one or more software modules. In addition to executing an operating system, the processor may be configured to execute one or more software applications, including a web browser, a telephone application, an email program, or any other software application.

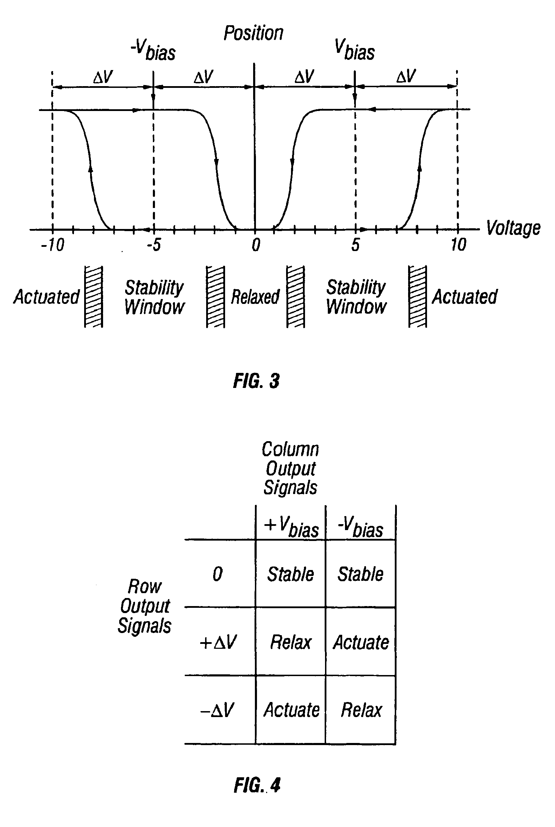

In one embodiment, the processor 21 is also configured to communicate with an array controller 22. In one embodiment, the array controller 22 includes a row driver circuit 24 and a column driver circuit 26 that provide signals to a display array or panel 30. The cross section of the array illustrated in Figure 1 is shown by the lines 1-1 in Figure 2. For MEMS interferometric modulators, the row/column actuation protocol may take advantage of a hysteresis property of these devices illustrated in Figure 3. It may require, for example, a 10 volt potential difference to cause a movable layer to deform from the relaxed state to the actuated state. However, when the voltage is reduced from that value, the movable layer maintains its state as the voltage drops back below 10 volts. In the exemplary embodiment of Figure 3, the movable layer does not relax completely until the voltage drops below 2 volts. There is thus a range of voltage, about 3 to 7 V in the example illustrated in Figure 3, where there exists a window of applied voltage within which the device is stable in either the relaxed or actuated state. This is referred to herein as the "hysteresis window" or "stability window." For a display array having the hysteresis characteristics of Figure 3, the row/column actuation protocol can be designed such that during row strobing, pixels in the strobed row that are to be actuated are exposed to a voltage difference of about 10 volts, and pixels that are to be relaxed are exposed to a voltage difference of close to zero volts. After the strobe, the pixels are exposed to a steady state voltage difference of about 5 volts such that they remain in whatever state the row strobe put them in. After being written, each pixel sees a potential difference within the "stability window" of 3-7 volts in this example. This feature makes the pixel design illustrated in Figure 1 stable under the same applied voltage conditions in either an actuated or relaxed pre-existing state. Since each pixel of the interferometric modulator, whether in the actuated or relaxed state, is essentially a capacitor formed by the fixed and moving reflective layers, this stable state can be held at a voltage within the hysteresis window with almost no power dissipation. Essentially no current flows into the pixel if the applied potential is fixed.

In typical applications, a display frame may be created by asserting the set of column electrodes in accordance with the desired set of actuated pixels in the first row. A row pulse is then applied to the row 1 electrode, actuating the pixels corresponding to the asserted column lines. The asserted set of column electrodes is then changed to correspond to the desired set of actuated pixels in the second row. A pulse is then applied to the row 2 electrode, actuating the appropriate pixels in row 2 in accordance with the asserted column electrodes. The row 1 pixels are unaffected by the row 2 pulse, and remain in the state they were set to during the row 1 pulse. This may be repeated for the entire series of rows in a sequential fashion to produce the frame. Generally, the frames are refreshed and/or updated with new display data by continually repeating this process at some desired number of frames per second. A wide variety of protocols for driving row and column electrodes of pixel arrays to produce display frames are also well known and may be used in conjunction with the present invention.

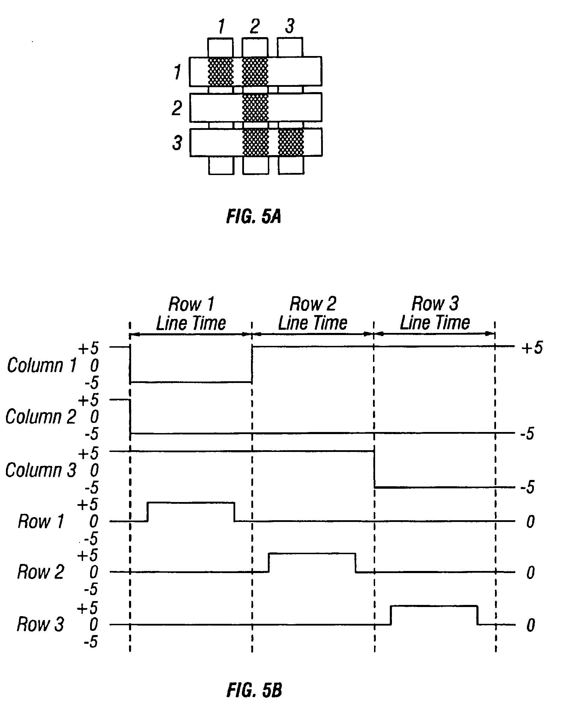

Figures 4 and 5 illustrate one possible actuation protocol for creating a display frame on the 3x3 array of Figure 2. Figure 4 illustrates a possible set of column and row voltage levels that may be used for pixels exhibiting the hysteresis curves of Figure 3. In the Figure 4 embodiment, actuating a pixel involves setting the appropriate column to-V_{bias}, and the appropriate row to +ΔV, which may correspond to -5 volts and +5 volts respectively. Relaxing the pixel is accomplished by setting the appropriate column to +V_{bias}, and the appropriate row to the same +ΔV, producing a zero volt potential difference across the pixel. In those rows where the row voltage is held at zero volts, the pixels are stable in whatever state they were originally in, regardless of whether the column is at +V_{bias}, or-V_{bias}. As is also illustrated in Figure 4, it will be appreciated that voltages of opposite polarity than those described above can be used, e.g., actuating a pixel can involve setting the appropriate column to +V_{bias}, and the appropriate row to -ΔV. In this embodiment, releasing the pixel is accomplished by setting the appropriate column to -V_{bias}, and the appropriate row to the same -ΔV, producing a zero volt potential difference across the pixel.

Figure 5B is a timing diagram showing a series of row and column signals applied to the 3x3 array of Figure 2 which will result in the display arrangement illustrated in Figure 5A, where actuated pixels are non-reflective. Prior to writing the frame illustrated in Figure 5A, the pixels can be in any state, and in this example, all the rows are at 0 volts, and all the columns are at +5 volts. With these applied voltages, all pixels are stable in their existing actuated or relaxed states.

In the Figure 5A frame, pixels (1,1), (1,2), (2,2), (3,2) and (3,3) are actuated. To accomplish this, during a "line time" for row 1, columns 1 and 2 are set to-5 volts, and column 3 is set to +5 volts. This does not change the state of any pixels, because all the pixels remain in the 3-7 volt stability window. Row 1 is then strobed with a pulse that goes from 0, up to 5 volts, and back to zero. This actuates the (1,1) and (1,2) pixels and relaxes the (1,3) pixel. No other pixels in the array are affected. To set row 2 as desired, column 2 is set to -5 volts, and columns 1 and 3 are set to +5 volts. The same strobe applied to row 2 will then actuate pixel (2,2) and relax pixels (2,1) and (2,3). Again, no other pixels of the array are affected. Row 3 is similarly set by setting columns 2 and 3 to -5 volts, and column 1 to +5 volts. The row 3 strobe sets the row 3 pixels as shown in Figure 5A. After writing the frame, the row potentials are zero, and the column potentials can remain at either +5 or-5 volts, and the display is then stable in the arrangement of Figure 5A. It will be appreciated that the same procedure can be employed for arrays of dozens or hundreds of rows and columns. It will also be appreciated that the timing, sequence, and levels of voltages used to perform row and column actuation can be varied widely within the general principles outlined above, and the above example is exemplary only, and any actuation voltage method can be used with the systems and methods described herein.

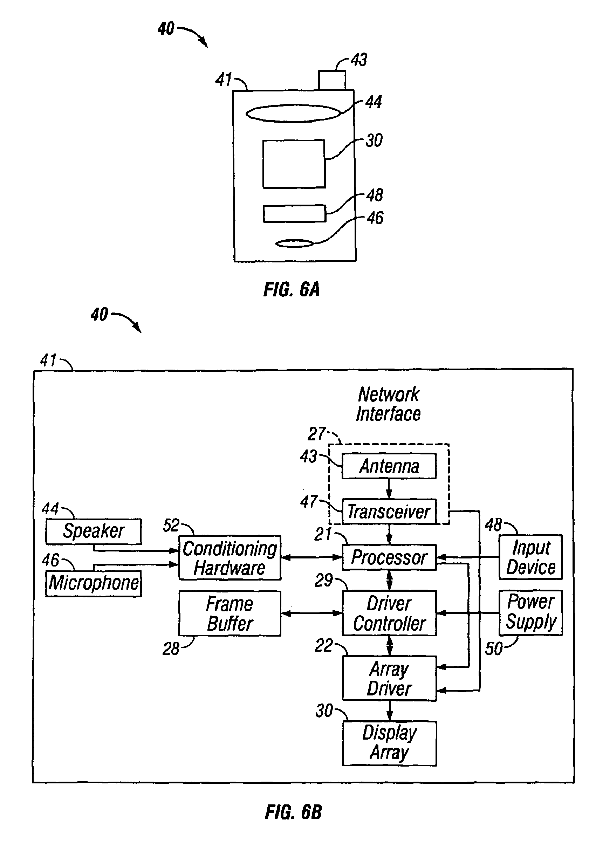

Figures 6A and 6B are system block diagrams illustrating an embodiment of a display device 40. The display device 40 can be, for example, a cellular or mobile telephone. However, the same components of display device 40 or slight variations thereof are also illustrative of various types of display devices such as televisions and portable media players.

The display device 40 includes a housing 41, a display 30, an antenna 43, a speaker 44, an input device 48, and a microphone 46. The housing 41 is generally formed from any of a variety of manufacturing processes as are well known to those of skill in the art, including injection molding, and vacuum forming. In addition, the housing 41 may be made from any of a variety of materials, including but not limited to plastic, metal, glass, rubber, and ceramic, or a combination thereof. In one embodiment the housing 41 includes removable portions (not shown) that may be interchanged with other removable portions of different color, or containing different logos, pictures, or symbols.

The display 30 of exemplary display device 40 may be any of a variety of displays, including a bi-stable display, as described herein. In other embodiments, the display 30 includes a flat-panel display, such as plasma, EL, OLED, STN LCD, or TFT LCD as described above, or a non-flat-panel display, such as a CRT or other tube device, as is well known to those of skill in the art. However, for purposes of describing the present embodiment, the display 30 includes an interferometric modulator display, as described herein.

The components of one embodiment of exemplary display device 40 are schematically illustrated in Figure 6B. The illustrated exemplary display device 40 includes a housing 41 and can include additional components at least partially enclosed therein. For example, in one embodiment, the exemplary display device 40 includes a network interface 27 that includes an antenna 43 which is coupled to a transceiver 47. The transceiver 47 is connected to a processor 21, which is connected to conditioning hardware 52. The conditioning hardware 52 may be configured to condition a signal (e.g. filter a signal). The conditioning hardware 52 is connected to a speaker 44 and a microphone 46. The processor 21 is also connected to an input device 48 and a driver controller 29. The driver controller 29 is coupled to a frame buffer 28, and to an array driver 22, which in turn is coupled to a display array 30. A power supply 50 provides power to all components as required by the particular exemplary display device 40 design.

The network interface 27 includes the antenna 43 and the transceiver 47 so that the exemplary display device 40 can communicate with one ore more devices over a network. In one embodiment the network interface 27 may also have some processing capabilities to relieve requirements of the processor 21. The antenna 43 is any antenna known to those of skill in the art for transmitting and receiving signals. In one embodiment, the antenna transmits and receives RF signals according to the IEEE 802.11 standard, including IEEE 802.11(a), (b), or (g). In another embodiment, the antenna transmits and receives RF signals according to the BLUETOOTH standard. In the case of a cellular telephone, the antenna is designed to receive CDMA, GSM, AMPS or other known signals that are used to communicate within a wireless cell phone network. The transceiver 47 pre-processes the signals received from the antenna 43 so that they may be received by and further manipulated by the processor 21. The transceiver 47 also processes signals received from the processor 21 so that they may be transmitted from the exemplary display device 40 via the antenna 43.

In an alternative embodiment, the transceiver 47 can be replaced by a receiver. In yet another alternative embodiment, network interface 27 can be replaced by an image source, which can store or generate image data to be sent to the processor 21. For example, the image source can be a digital video disc (DVD) or a hard-disc drive that contains image data, or a software module that generates image data.

Processor 21 generally controls the overall operation of the exemplary display device 40. The processor 21 receives data, such as compressed image data from the network interface 27 or an image source, and processes the data into raw image data or into a format that is readily processed into raw image data. The processor 21 then sends the processed data to the driver controller 29 or to frame buffer 28 for storage. Raw data typically refers to the information that identifies the image characteristics at each location within an image. For example, such image characteristics can include color, saturation, and gray-scale level.

In one embodiment, the processor 21 includes a microcontroller, CPU, or logic unit to control operation of the exemplary display device 40. Conditioning hardware 52 generally includes amplifiers and filters for transmitting signals to the speaker 44, and for receiving signals from the microphone 46. Conditioning hardware 52 may be discrete components within the exemplary display device 40, or may be incorporated within the processor 21 or other components.

The driver controller 29 takes the raw image data generated by the processor 21 either directly from the processor 21 or from the frame buffer 28 and reformats the raw image data appropriately for high speed transmission to the array driver 22. Specifically, the driver controller 29 reformats the raw image data into a data flow having a raster-like format, such that it has a time order suitable for scanning across the display array 30. Then the driver controller 29 sends the formatted information to the array driver 22. Although a driver controller 29, such as a LCD controller, is often associated with the system processor 21 as a stand-alone Integrated Circuit (IC), such controllers may be implemented in many ways. They may be embedded in the processor 21 as hardware, embedded in the processor 21 as software, or fully integrated in hardware with the array driver 22.

Typically, the array driver 22 receives the formatted information from the driver controller 29 and reformats the video data into a parallel set of waveforms that are applied many times per second to the hundreds and sometimes thousands of leads coming from the display's x-y matrix of pixels.

In one embodiment, the driver controller 29, array driver 22, and display array 30 are appropriate for any of the types of displays described herein. For example, in one embodiment, driver controller 29 is a conventional display controller or a bi-stable display controller (e.g., an interferometric modulator controller). In another embodiment, array driver 22 is a conventional driver or a bi-stable display driver (e.g., an interferometric modulator display). In one embodiment, a driver controller 29 is integrated with the array driver 22. Such an embodiment is common in highly integrated systems such as cellular phones, watches, and other small area displays. In yet another embodiment, display array 30 is a typical display array or a bi-stable display array (e.g., a display including an array of interferometric modulators).

The input device 48 allows a user to control the operation of the exemplary display device 40. In one embodiment, input device 48 includes a keypad, such as a QWERTY keyboard or a telephone keypad, a button, a switch, a touch-sensitive screen, a pressure- or heat-sensitive membrane. In one embodiment, the microphone 46 is an input device for the exemplary display device 40. When the microphone 46 is used to input data to the device, voice commands may be provided by a user for controlling operations of the exemplary display device 40.

Power supply 50 can include a variety of energy storage devices as are well known in the art. For example, in one embodiment, power supply 50 is a rechargeable battery, such as a nickel-cadmium battery or a lithium ion battery. In another embodiment, power supply 50 is a renewable energy source, a capacitor, or a solar cell, including a plastic solar cell, and solar-cell paint. In another embodiment, power supply 50 is configured to receive power from a wall outlet.

In some implementations control programmability resides, as described above, in a driver controller which can be located in several places in the electronic display system. In some cases control programmability resides in the array driver 22. Those of skill in the art will recognize that the above-described optimization may be implemented in any number of hardware and/or software components and in various configurations.

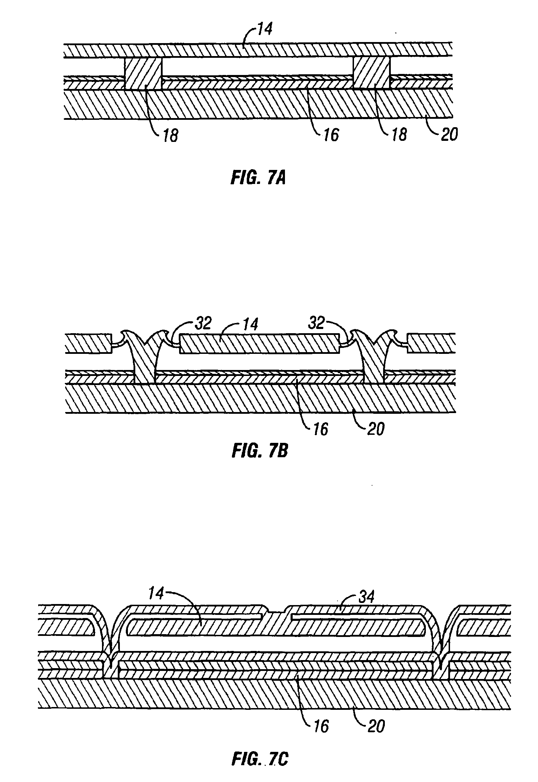

The details of the structure of interferometric modulators that operate in accordance with the principles set forth above may vary widely. For example, Figures 7A-7C illustrate three different embodiments of the moving mirror structure. Figure 7A is a cross section of the embodiment of Figure 1, where a strip of metal material 14 is deposited on orthogonally extending supports 18. In Figure 7B, the moveable reflective material 14 is attached to supports at the corners only, on tethers 32. In Figure 7C, the moveable reflective material 14 is suspended from a deformable layer 34. This embodiment has benefits because the structural design and materials used for the reflective material 14 can be optimized with respect to the optical properties, and the structural design and materials used for the deformable layer 34 can be optimized with respect to desired mechanical properties. The production of various types of interferometric devices is described in a variety of published documents, including, for example, U.S. Published Application 2004/0051929. A wide variety of known techniques may be used to produce the above described structures involving a series of material deposition, patterning, and etching steps.

The moving parts of a MEMS device, such as an interferometric modulator array, preferably have a protected space in which to move. Packaging techniques for a MEMS device will be described in more detail below. A schematic of a basic package structure for a MEMS device, such as an interferometric modulator array, is illustrated in Figure 8. As shown in Figure 8, a basic package structure 70 includes a substrate 72 and a backplane cover or "cap" 74, wherein an interferometric modulator array 76 is formed on the substrate 72. This cap 74 is also called a "backplane".

The substrate 72 and the backplane 74 are joined by a seal 78 to form the package structure 70, such that the interferometric modulator array 76 is encapsulated by the substrate 72, backplane 74, and the seal 78. This forms a cavity 79 between the backplane 74 and the substrate 72. The seal 78 may be a non-hermetic seal, such as a conventional epoxy-based adhesive. In other embodiments, the seal 78 may be a polyisobutylene (sometimes called butyl rubber, and other times PIB), o-rings, polyurethane, thin film metal weld, liquid spin-on glass, solder, polymers, or plastics, among other types of seals that may have a range of permeability of water vapor of about 0.2 - 4.7 g mm/m2kPa day. In still other embodiments, the seal 78 may be a hermetic seal and may comprise, for example, metals, welds, and glass frits. Methods of hermetic sealing comprise, for example, metal or solder thin film or preforms, laser or resistive welding techniques, and anodic bonding techniques, wherein the resulting package structure may or may not require a desiccant to achieve the desired internal package requirements.

The seal 78 may be implemented as a closed seal (continuous) or an open seal (non-continuous), and may be applied or formed on the substrate 72, backplane 74, or both the substrate and backplane 74 in a method of packaging the interferometric modulator array 76. The seal 78 may be applied through simple in-line manufacturing processes and may have advantages for lower temperature processes, whereas the techniques of welding and soldering may require very high temperature processes that can damage the package structure 20, are relatively expensive. In some cases, localized heating methods can be used to reduce the process temperatures and yield a viable process solution.

In some embodiments, the package structure 70 includes a getter such as a desiccant 80 configured to reduce moisture within the cavity 79. The skilled artisan will appreciate that a desiccant may not be necessary for a hermetically sealed package, but may be desirable to control moisture resident within the package or outgassed materials from inside the package. In one embodiment, the desiccant 80 is positioned between the interferometric modulator array 76 and the backplane 74. Desiccants may be used for packages that have either hermetic or non-hermetic seals. In packages having a hermetic seal, desiccants are typically used to control moisture resident within the interior of the package. In packages having a non-hermetic seal, a desiccant may be used to control moisture moving into the package from the environment. Generally, any substance that can trap moisture while not interfering with the optical properties of the interferometric modulator array may be used as the desiccant 80. Suitable getter and desiccant materials include, but are not limited to, zeolites, molecular sieves, surface adsorbents, bulk adsorbents, and chemical reactants.

The desiccant 80 may be in different forms, shapes, and sizes. In addition to being in solid form, the desiccant 80 may alternatively be in powder form. These powders may be inserted directly into the package or they may be mixed with an adhesive for application. In an alternative embodiment, the desiccant 80 may be formed into different shapes, such as cylinders, rings, or sheets, before being applied inside the package.

The skilled artisan will understand that the desiccant 80 can be applied in different ways. In one embodiment, the desiccant 80 is deposited as part of the interferometric modulator array 76. In another embodiment, the desiccant 80 is applied inside the package 70 as a spray or a dip coat.

The substrate 72 may be a semi-transparent or transparent substance capable of having thin film, MEMS devices built upon it. Such transparent substances include, but are not limited to, glass, plastic, and transparent polymers. The interferometric modulator array 76 may comprise membrane modulators or modulators of the separable type. The skilled artisan will appreciate that the backplane 74 may be formed of any suitable material, such as glass, metal, foil, polymer, plastic, ceramic, or semiconductor materials (e.g., silicon).

The packaging process may be accomplished in a vacuum, pressure between a vacuum up to and including ambient pressure, normal atmospheric pressure conditions, or pressure higher than ambient pressure. The packaging process may also be accomplished in an environment of varied and controlled high or low pressure during the sealing process. There may be advantages to packaging the interferometric modulator array 76 in a completely dry environment, but it is not necessary. Similarly, the packaging environment may be of an inert gas at ambient conditions. Packaging at ambient conditions allows for a lower cost process and more potential for versatility in equipment choice because the device may be transported through ambient conditions without affecting the operation of the device.

Generally, it is desirable to minimize the permeation of water vapor into the package structure 70, and thus control the environment in the cavity 79 of the package structure 70 and hermetically seal it to ensure that the environment remains constant. When the humidity or water vapor level within the package exceeds a level beyond which surface tension from the water vapor becomes higher than the restoration force of a movable element (not shown) in the interferometric modulator array 76, the movable element may become permanently adhered to the surface. There is thus a need to reduce the moisture level within the package.

During manufacturing of a MEMS device, such as an interferometric modulator array, it may be necessary to expose the individual package structure components, such as the backplane, to ambient conditions. For example, the backplane 74 may be manufactured separately from the other components of the display. Accordingly, the backplane 74 may sit days, weeks, or longer at ambient conditions prior to being contacted with the seal 78 and substrate 72. For this reason, it may be advantageous to preserve the desiccant 80 that is disposed on the backplane 74 so that it is not exposed to water vapor prior to being assembled in the package structure 70. Thus, certain embodiments of the invention include a MEMS device package having an inactive or protected desiccant, wherein the inactive or protected desiccant is activated immediately prior to assembly of the package or after assembly of the package. In some embodiments, the inactive desiccant is activated by exposure to environmental changes such as heat or light, and in other embodiments, the inactive desiccant is activated by removing a protective layer from a surface of the desiccant. In certain embodiments, the inactive desiccant is activated by exposing the desiccant to an activating substance.

Figure 9 is a cross-sectional view of one embodiment of a MEMS device package with an inactive desiccant, wherein the inactive desiccant comprises the desiccant 80 and a protective layer 88. The protective layer 88 is configured to eliminate or reduce water transport from the environment to the desiccant. For example, the protective layer 88 may include any material that prevents water molecules from contacting the desiccant 37, but can be removed at a later stage in manufacturing or assembly. The protective layer 88 may comprise, for example, metals, oxides, plastics, or other materials compatible with the MEMS device processing. Specifically, the protective layer 88 may comprise one or more of the following: Au, Ag, Al, Si, Ti, W, SiO₂, Mo, polymeric materials, plasma, a hard-baked photresist, and/or polyimide. The protective layer 88 can be deposited by any well-known method including chemical vapor deposition (CVD), layering, extrusion, and manual application or placement.

In one embodiment, the protective layer 88 is removed after the package structure is assembled, wherein the package structure 70 is assembled by contacting the backplane 74, the seal 78, and the substrate 72. In certain embodiments, the protective layer 88 is removed from the desiccant 80 by contacting the protective layer 88 with a removal substance, wherein the removal substance is introduced into the cavity 79 of the package structure 70 through an aperture in at least one of the backplane 74, the seal 78, and the substrate 72. In the embodiment illustrated in Figure 9, an aperture 90 is formed in the backplane 74, thereby providing an inlet to the cavity 79 from the exterior of the MEMS device package structure 70. The aperture 90 may be formed in the package structure before or after assembly and may be present on the backplane 74 prior to application of the desiccant 80.

The protective layer 88 can be contacted with a removal substance by inputting the removal substance through the aperture 90, wherein the removal substance is configured to remove the protective layer 88 from the desiccant 80 and thereby activate the desiccant. The removal substance may be a gas or liquid, for example, configured to remove the protective layer 88 from within the cavity 79 of the package structure 70. In certain embodiments, the removal substance and the protective layer material are also removed from the device package structure 70 through the aperture 90 using a vacuum process, for example.

As discussed above, the aperture 90 may be formed in the package structure 70 at locations other than the backplane 74, such as in the seal 78 or the substrate 72. In some embodiments, the aperture is formed in the backplane, the desiccant 80, and the protective layer 88. In other embodiments, the seal 78 is an open or non-continuous seal wherein the opening in the seal 78 is used both to release pressure between the backplane 74 and the substrate 72 during assembly of the package structure 70, and to remove the protective layer 88. In certain embodiments, the aperture 90 has a diameter sufficiently small to block influx of water molecules into the cavity 79 of the package structure, and large enough to allow the influx of a removal substance for removal of the protective layer 88.

In other embodiments, the protective layer 88 may be removed from the desiccant 80 by exposure of the protective layer to an environmental change, such as exposure to heat such that the protective layer evaporates or sublimates, or ultraviolet light. The removed protective layer 88 preferably does not interfere with operation of the interferometric modulator array 76, and the removed protective layer (or remaining components thereof) may be removed via the aperture 90. In some embodiments, the package structure 70 comprises an additional desiccant configured to capture residual components of the protective layer 88 when removed from the desiccant 80, such as when the protective layer 88 is evaporated or sublimated from the desiccant 80 in response to an application of heat.

Examples of substances for removal of the protective layer 88 include gasses, liquids, and plasmas configured to remove the protective layer 88 but not damage the desiccant 80 or other components of the package structure 70. For example, a protective layer comprising a photoresist or polyimide can be removed using an oxygen plasma.

In certain embodiments, the protective layer 88 comprises the same or a similar material as a material used in the intervening sacrificial material of the interferometric modulator array 76 discussed above in reference to Figure 1. In such embodiments, the sacrificial material of the interferometric modulator array 76 and the protective layer 88 can be removed during the same removal step using the same removal substance, thereby reducing manufacturing steps and chemicals. The protective layer 88 and sacrificial material may comprise, for example, Mo, Al-Si, Ti, and W, and the removal substance or etchant may comprise XeFl₂.

In the embodiment wherein the desiccant 80 is activated by exposure to an activation substance, the activation substance is input to the package structure cavity 79 through the aperture 90 so as to contact the desiccant 80. Following activation of the desiccant 80, the activation substance is removed from the cavity 79 through the aperture 90. The activation substance may comprise a gas, liquid, or plasma.

In embodiments of the package structure 70 wherein the desiccant 80 is activated in response to exposure to heat, materials exported from the desiccant 80 in response to activation may be removed from the package structure cavity 79 via the aperture 90. For example, in an embodiment where the desiccant comprises zeolites and water molecules are released in response to exposure to heat, the released water molecules are removed from the cavity 79 through the aperture 90 employing a vacuum process.

Following activation of the desiccant 80 by removal of the protective layer 88, for example, the aperture 90 may be sealed to prevent elements of the ambient environment from entering the chamber 79 of the package structure 70. In one embodiment, the same material that is used for the seal 78 is used to close or plug the aperture 90. In other embodiments, the same or similar material as that used for the backplane 74 is used to close the aperture 90. Alternatively, a diameter of the aperture 90 may be small enough such that water molecules cannot pass through the aperture 90 into the chamber 79 of the package structure 70.

In one embodiment, the desiccant 80 is activated prior to assembly of the device package structure 70, wherein assembly comprises contacting the backplane 74, the seal 78, and the substrate 72. Figure 10 is a cross-sectional view of an unassembled package structure 900 wherein the protective layer 88 comprises a self-contained sheet configured to eliminate or reduce water transport to the desiccant 80. The self-contained sheet may comprise, for example, a metal foil and/or polymer. In the embodiment illustrated in Figure 10, the protective layer 88 is removed from the desiccant 80, thereby activating the desiccant, prior to assembly of the package structure 900. The self-contained sheet may be removed manually, or may be removed by exposure to environmental changes such as heat or light.

In embodiments wherein the desiccant 80 is configured for activation in response to an environmental change, the package structure may be assembled prior to activation of the desiccant 80 and no aperture is necessarily required to facilitate activation of the desiccant 80 or removal of any substance. For example, wherein the desiccant 80 is configured for activation in response to exposure to heat or UV light, a method of packaging a device such as an interferometric modulator device comprises providing a substrate with an interferometric modulator device formed thereon, a backplane sealed to the substrate so as to encapsulate the interferometric modulator device, and an inactive desiccant within the package structure. The method further comprises activating the desiccant by exposing the desiccant to an environmental change, such as heat or UV light. In addition, the package may include an aperture, wherein the desiccant is activated via the aperture using a heated gas, for example. In some embodiments, the package may include an additional desiccant configured to capture materials released from the inactive desiccant upon activation.

While the above detailed description has shown, described, and pointed out novel features of the invention as applied to various embodiments, it will be understood that various omissions, substitutions, and changes in the form and details of the device or process illustrated may be made by those skilled in the art without departing from the spirit of the invention. As will be recognized, the present invention may be embodied within a form that does not provide all of the features and benefits set forth herein, as some features may be used or practiced separately from others.

## Claims

1. A method of manufacturing a microelectromechanical system (MEMS) device, comprising:
providing a MEMS device package comprising a substrate comprising a MEMS device formed thereon;
providing a backplane sealed to said substrate to encapsulate said MEMS device;
providing an inactive desiccant positioned within said MEMS device package; and
activating said desiccant.

2. The method of Claim 1, wherein said desiccant is disposed on said backplane.

3. The method of Claim 1, wherein said desiccant is disposed on said substrate.

4. The method of Claim 1, wherein activating said desiccant comprises removing a protective layer from a surface of said desiccant.

5. The method of Claim 1, wherein activating said desiccant comprises exposing said desiccant to heat.

6. The method of Claim 1, wherein activating said desiccant comprises exposing said desiccant to UV light.

7. The method of Claim 1, wherein activating said desiccant comprises contacting said inactive desiccant with a substance through an aperture in at least one of said backplane, said seal, and said substrate.

8. The method of Claim 1, wherein said inactive desiccant comprises a protective layer positioned over a desiccant, and wherein activating said desiccant comprises removing said protective layer.

9. The method of Claim 8, wherein removing said protective layer comprises exposing said desiccant to heat.

10. The method of Claim 7, wherein said substance is one of a gas, a liquid, and a plasma.

11. The method of Claim 7, further comprising filling said aperture with a substance to seal the MEMS device package from ambient conditions.

12. A microelectromechanical system (MEMS) device produced by the method of any one of claims 1 to 11.

13. A microelectromechanical system (MEMS) device, comprising:
transmitting means for transmitting light therethrough;
modulating means for modulating light through said transmitting means;
covering means for covering said modulating means and forming a package; and
removing means for removing water vapor from within said package, wherein said removing means is in an inactive state.

14. The device of Claim 13, wherein said transmitting means comprises a transparent substrate.

15. The device of Claim 13 or 14, wherein said modulating means comprises an interferometric modulator.

16. The device of Claim 13, 14, or 15, wherein said covering means comprises a backplane.

17. The device of Claim 13, 14, 15, or 16, wherein said removing means comprises an inactive desiccant.

18. The device of Claim 17, wherein said inactive desiccant comprises a desiccant comprising a protective layer.

19. The device of Claim 17, wherein said inactive desiccant is activated by exposing said desiccant to heat.

20. The device of Claim 17, wherein said inactive desiccant is activated by exposing said desiccant to UV light.

21. The device of Claim 17, wherein said inactive desiccant is activated by exposing said desiccant to a substance.

22. The device of Claim 21, wherein said covering means comprises at least one aperture, wherein said desiccant is activated by contact with a substance introduced through said aperture.

23. The device of Claim 21, wherein said inactive desiccant comprises a protective layer positioned over a desiccant, and wherein said substance is configured to remove said protective layer.

24. The device of Claim 13, further comprising:
a processor that is in electrical communication with said modulating means, said processor being configured to process image data; and
a memory device in electrical communication with said processor.

25. The device of Claim 24, further comprising a controller configured to send at least a portion of said image data to an electrical component, wherein said electrical component comprises a driver circuit.

26. The device of Claim 24, further comprising an image source module configured to send image data to said processor.

27. The device of Claim 26, wherein said image source module comprises at least one of a receiver, transceiver, and transmitter.

28. The device of Claim 24, further comprising an input device configured to receive input data and to communicate said input data to said processor.
